# EUROPEAN PATENT APPLICATION

(11) **EP 4 679 947 A1**
(43) Date of publication of application: **14.01.2026**
(21) Application number: 24766937.7
(22) Date of filing: 27.02.2024
(51) Int. Cl.: H05K 3/20, H05K 1/02

(54) **METHOD FOR PRODUCING CIRCUIT PATTERN, METHOD FOR PRODUCING CIRCUIT BOARD, AND CIRCUIT PATTERN**

(30) Priority: 07.03.2023 JP 2023034483
(71) Applicant: NHK Spring Co., Ltd., Yokohama-shi, Kanagawa 236-0004 (JP)
(72) Inventor: YANO, Shinya, Yokohama-shi, Kanagawa 236-0004 (JP)
(74) Representative: TBK
(86) International application number: PCT/JP2024/006976
(87) International publication number: WO 2024/185566

(57) **Abstract**

Provided is a method for producing a circuit pattern, the method capable of satisfactorily plating a circuit pattern bonded to a release sheet and satisfactorily peeling the plated circuit pattern from the release sheet.

The method for producing a circuit pattern includes: a step of plating a predetermined portion on a surface of a metal plate (11); a step of bonding a release sheet (14) to a back surface of the plated metal plate (11); a step of providing a resist pattern (17) covering the plating on the surface of the metal plate (11); and a step of forming a circuit pattern (2) bonded to the release sheet (14) by etching the metal plate (11) provided with the resist pattern (17).

## Description

### Technical Field

The present invention relates to a method for producing a circuit pattern, a method for producing a circuit board, and a circuit pattern.

### Background Art

Conventionally, various circuit boards have been used. For example, Patent Literature 1 discloses a method for producing a circuit board used for mounting an electronic component used for a power module or the like.

In the production method of Patent Literature 1, a metal plate is bonded to a ceramic substrate, a circuit pattern-shaped resist is printed on the metal plate, and an unnecessary portion is removed by etching to form a circuit pattern. Thereafter, plating is applied to the surface of the circuit pattern to form a circuit board.

Meanwhile, since an electronic component in a power module generates a large amount of heat, a circuit board in which a circuit pattern is laminated on a base substrate made of a metal with an insulating layer interposed therebetween has been studied in order to enhance heat dissipation.

Here, Patent Literature 2 discloses a technique in which an electrolytic metal foil is provided peelably on a transfer sheet (release sheet), the electrolytic metal foil is etched to form a circuit pattern, and the formed circuit pattern is brought into close contact with an object to peel off the transfer sheet, thereby transferring the circuit pattern to the object. Therefore, there is a possibility that the circuit board as described above can be obtained by using such a technique of transferring a circuit pattern.

### Citation List

### Patent Literatures

Patent Literature 1: JP 3795354 B2
Patent Literature 2: JP 2572071 B2

### Summary of Invention

### Technical Problem

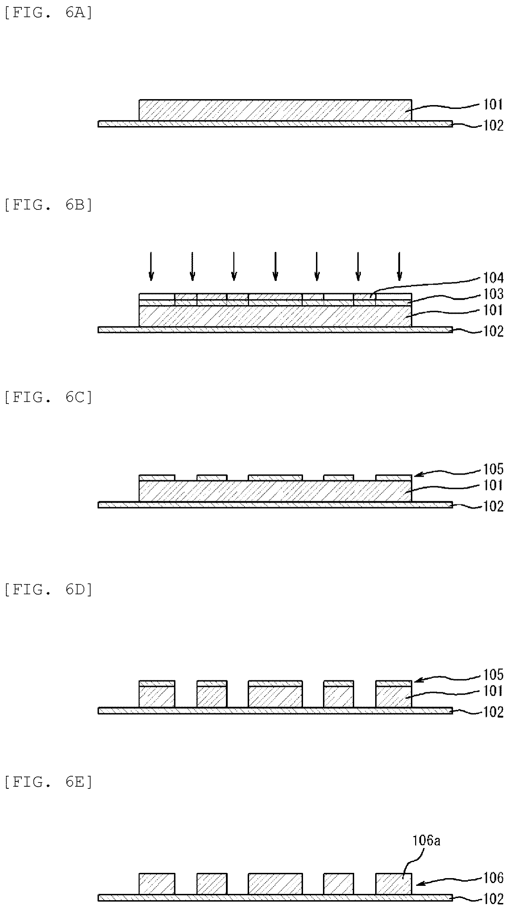

However, in the case of using the technique as disclosed in Patent Literature 2, a defect has been found when plating is applied to the etched circuit pattern. This point will be described with reference to Fig. 6A and the like.

First, as illustrated in Fig. 6A, a release sheet 102 is bonded to a back surface of a metal plate 101. The metal plate 101 is, for example, a copper plate. The release sheet 102 is, for example, a UV sheet. Since the UV sheet has a property that an initial adhesive force is reduced by ultraviolet irradiation, the UV sheet can be easily peeled off from the bonded object by irradiating the UV sheet with ultraviolet rays at the time of peeling off the UV sheet.

Then, as illustrated in Fig. 6B, a dry film 103 is bonded to a surface of the metal plate 101, and an exposure film 104 is disposed on a surface of the dry film 103 to perform exposure. When exposure is performed, the dry film 103 is cured in a portion where light passes through an opening of the exposure film 104. Thereafter, a developing step of removing a portion of the dry film 103 which is not cured by exposure is performed. As a result, as illustrated in Fig. 6C, a partially opened resist pattern 105 is formed on the surface of the metal plate 101.

Next, when etching is performed, as illustrated in Fig. 6D, the metal plate 101 is dissolved so as to penetrate in the thickness direction at the portion where the opening of the resist pattern 105 is provided. Thereafter, when the resist pattern 105 is removed with an alkaline solution, a circuit pattern 106 is formed on the release sheet 102 as illustrated in Fig. 6E. The circuit pattern 106 includes a plurality of electrically independent conductor portions 106a.

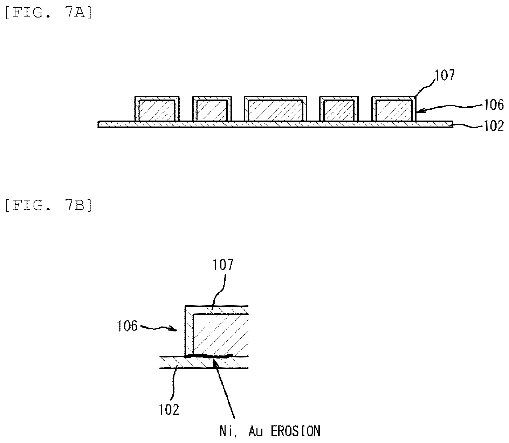

Thereafter, plating is performed on the circuit pattern 106. The plating is, for example, electroless Ni-P/Au plating, but is not limited thereto, and various types of plating such as Ag plating, Ni plating, and Au plating can be adopted. The film thickness of plating is not particularly limited. In the present embodiment, electroless Ni-P/Au plating is applied to the circuit pattern 106, whereby a plating film (electroless Ni-P/Au plating film 107) is provided on the exposed surface (surface and side surface) in the circuit pattern 106 as illustrated in Fig. 7A.

However, when the circuit pattern 106 after plating was confirmed, as illustrated in Fig. 7B, erosion of Ni or Au was observed at a boundary surface between the circuit pattern 106 and the release sheet 102. As a result of repeated studies on this point, hydrogen gas was generated in a Ni plating step, and this hydrogen gas peeled the release sheet 102 from the circuit pattern 106, and this peeling was one of the causes of erosion of Ni or Au. Note that, when the release sheet 102 having a high initial adhesive force is used, there is a possibility that peeling of the release sheet 102 at the time of plating is suppressed and erosion of Ni or Au can be prevented. However, since the release sheet 102 having a high initial adhesive force also has a high adhesive force after ultraviolet irradiation, it is difficult to peel off the release sheet 102 from the circuit pattern 106 in the subsequent step. When the release sheet 102 is forcibly peeled off from the circuit pattern 106, the positional relationship of the plurality of independent conductor portions 106a is affected, and the intended circuit pattern 106 cannot be obtained.

In view of such problems, an object of the present invention is to provide a method for producing a circuit pattern, the method capable of satisfactorily plating a circuit pattern bonded to a release sheet and satisfactorily peeling the plated circuit pattern from the release sheet. In addition, a method for producing a circuit board using a technique related to the method for producing a circuit pattern, and a circuit pattern are also provided.

### Solution to Problem

The present invention is a method for producing a circuit pattern, the method including: a step of plating a predetermined portion on a surface of a metal plate; a step of bonding a release sheet to a back surface of the plated metal plate; a step of providing a resist pattern covering the plating on the surface of the metal plate; and a step of forming a circuit pattern bonded to the release sheet by etching the metal plate provided with the resist pattern.

The present invention is also a method for producing a circuit board by laminating the circuit pattern obtained by the above-described method for producing a circuit pattern on an insulating layer laminated on a base substrate, the method including: a step of transferring the circuit pattern to a transfer body; a step of peeling off the release sheet from the circuit pattern; and a step of transferring the circuit pattern from the transfer body to the insulating layer.

The present invention is also a circuit pattern in which a surface is plated and a release sheet is bonded to a back surface, in which the plating is located inside an edge portion of the surface in the circuit pattern.

### Advantageous Effects of Invention

According to the method for producing a circuit pattern of the present invention, it is possible to satisfactorily plate a circuit pattern bonded to a release sheet and satisfactorily peel the plated circuit pattern from the release sheet.

### Brief Description of Drawings

Fig. 1A is a side view illustrating an embodiment of a circuit board according to the present invention.
Fig. 1B is a partially enlarged view of the periphery of a conductor portion illustrated in Fig. 1.
Fig. 1C is a plan view of Fig. 1B.
Fig. 2A is a view relating to a method for producing a circuit pattern according to the present invention (view relating to step S1).
Fig. 2B is a view relating to the method for producing a circuit pattern according to the present invention (view relating to step S2).
Fig. 2C is a view relating to the method for producing a circuit pattern according to the present invention (view relating to step S3).
Fig. 2D is a view relating to the method for producing a circuit pattern according to the present invention (view relating to step S4).
Fig. 2E is a view relating to the method for producing a circuit pattern according to the present invention (view relating to step S5).
Fig. 3A is a view relating to the method for producing a circuit pattern according to the present invention (view relating to step S6).
Fig. 3B is a view relating to the method for producing a circuit pattern according to the present invention (view relating to step S7).
Fig. 3C is a view relating to the method for producing a circuit pattern according to the present invention (view relating to step S8).
Fig. 3D is a view relating to the method for producing a circuit pattern according to the present invention (view relating to step S9).
Fig. 3E is a view relating to the method for producing a circuit pattern according to the present invention (view relating to step S10).
Fig. 4A is a view relating to a method for producing a circuit board according to the present invention (view relating to step S11).
Fig. 4B is a view relating to the method for producing a circuit board according to the present invention (view relating to step S12).
Fig. 4C is a view relating to the method for producing a circuit board according to the present invention (view relating to step S13).
Fig. 5 is a view illustrating steps relating to the method for producing a circuit pattern and the method for producing a circuit board according to the present invention.
Fig. 6A is a view relating to a method for producing a circuit pattern based on Patent Literature 2.
Fig. 6B is a view relating to a step performed after Fig. 6A.
Fig. 6C is a view relating to a step performed after Fig. 6B.
Fig. 6D is a view relating to a step performed after Fig. 6C.
Fig. 6E is a view relating to a step performed after Fig. 6D.
Fig. 7A is a view relating to a step performed after Fig. 6E.
Fig. 7B is a partially enlarged view of Fig. 7A.

### Description of Embodiments

Hereinafter, embodiments of a method for producing a circuit pattern, a method for producing a circuit board, and a circuit pattern according to the present invention will be described with reference to the accompanying drawings. Note that the drawings illustrated in the accompanying drawings are schematic, and the thickness and width of each portion, the ratio between the portions, and the like may be different from those actually implemented.

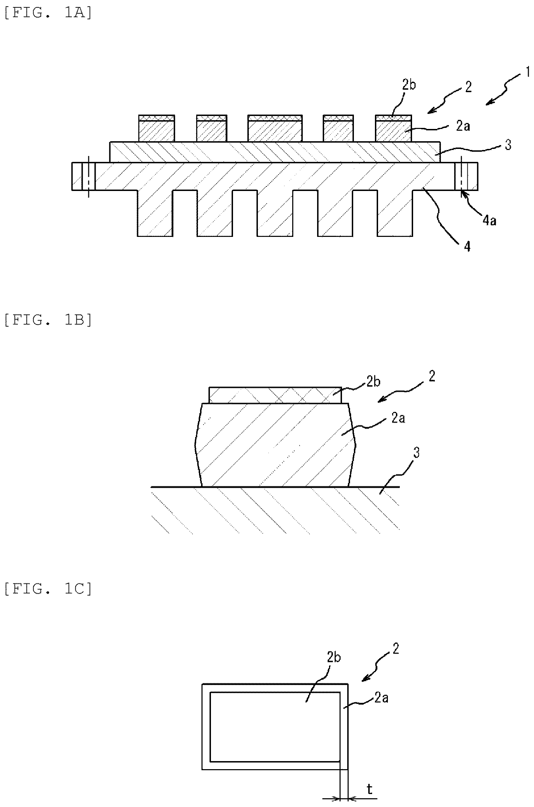

First, a circuit pattern and a circuit board as examples of products produced by the method for producing a circuit pattern and the method for producing a circuit board according to the present embodiment will be described with reference to Fig. 1A. A circuit board 1 illustrated in Fig. 1A is obtained by laminating a circuit pattern 2, an insulating layer 3, and a base substrate 4 in this order.

The circuit pattern 2 is processed into a predetermined pattern by etching a metal plate as described later. The circuit pattern 2 of the present embodiment is formed by etching a relatively thick copper plate (rolled copper), and includes a plurality of electrically independent conductor portions 2a. The thickness of the circuit pattern 2 can be appropriately selected according to the use application. The thickness of the circuit pattern 2 (thickness of thick copper) of the present embodiment is 0.5 to 2.0 mm.

As described later, in the present embodiment, electroless Ni-P/Au plating is applied to the metal plate before etching, whereby an electroless Ni-P/Au plating film 2b is provided on the conductor portion 2a as illustrated in Fig. 1B. As illustrated, the electroless Ni-P/Au plating film 2b is provided only on the surface of the conductor portion 2a, and is not provided on the side surface of the conductor portion 2a. The electroless Ni-P/Au plating film 2b is located inside the edge portion of the surface of the conductor portion 2a as illustrated in Fig. 1C. A distance t from the edge portion of the electroless Ni-P/Au plating film 2b to the edge portion of the conductor portion 2a is about 0.2 mm in the present embodiment.

The insulating layer 3 is formed of a material having an insulating property, and serves to electrically insulate the circuit pattern 2 and the base substrate 4 and to adhere them to each other. When an electronic component used for a power module or the like is mounted on the circuit pattern 2, the insulating layer 3 preferably has high heat resistance to heat generated from the electronic component and high heat transferability for transferring the heat to the base substrate 4. The insulating layer 3 may cover the entire surface of the base substrate 4 or a part of the surface.

Examples of the material of the insulating layer 3 include a resin composition containing a thermosetting resin. Examples of the thermosetting resin include an epoxy resin, a phenol resin, a melamine resin, a urea resin, an unsaturated polyester resin, an alkyd resin, and a cyanate resin. One thermosetting resin may be used alone, or two or more thermosetting resins may be used in combination. Examples of those contained in the resin composition other than the thermosetting resin include a curing agent. The curing agent is not particularly limited as long as it is selected according to the type of thermosetting resin and reacts with the thermosetting resin. Examples of the curing agent in the case of using an epoxy resin include an amine-based curing agent, an imidazole-based curing agent, and a phenol-based curing agent. The resin composition may contain a filler (inorganic filler). The filler is preferably one having excellent insulation properties and high thermal conductivity, and examples thereof include aluminum oxide, silica, aluminum nitride, boron nitride, silicon nitride, and magnesium oxide. The resin composition may further contain a curing accelerator, a stabilizer, an ion scavenger, a solvent, and the like. The resin composition may contain a softness imparting material.

The base substrate 4 can be formed of various materials, but is preferably formed of a material having a high thermal conductivity in particular, and is preferably formed of, for example, a metal such as copper, aluminum, or iron (may be a simple metal or an alloy). The base substrate 4 of the present embodiment is formed of copper. The illustrated base substrate 4 is provided with fins on the back surface in order to enhance the effect of releasing heat to the outside, but the base substrate 4 may have a plate shape without fins. The base substrate 4 of the present embodiment includes a through hole 4a used when being attached to another member, but the size, position, number, and the like of the through hole 4a can be arbitrarily set, and the through hole 4a may be omitted. The base substrate 4 is not limited to a single member, and may be formed by combining a plurality of members. The base substrate 4 may have a configuration that further improves the effect of releasing heat to the outside, and may be, for example, a configuration in which a vapor chamber or a heat pipe is embedded in a metal plate.

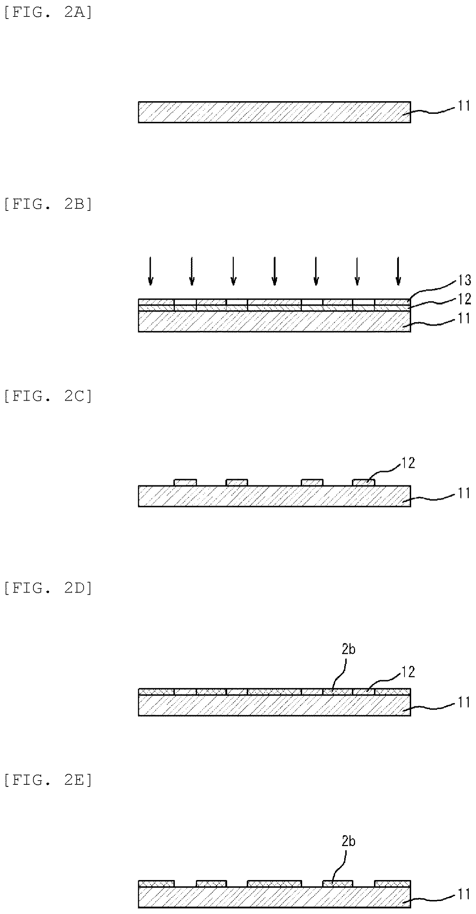

Next, the method for producing a circuit pattern and the method for producing a circuit board in the present embodiment will be described with reference to Figs. 2 to 5.

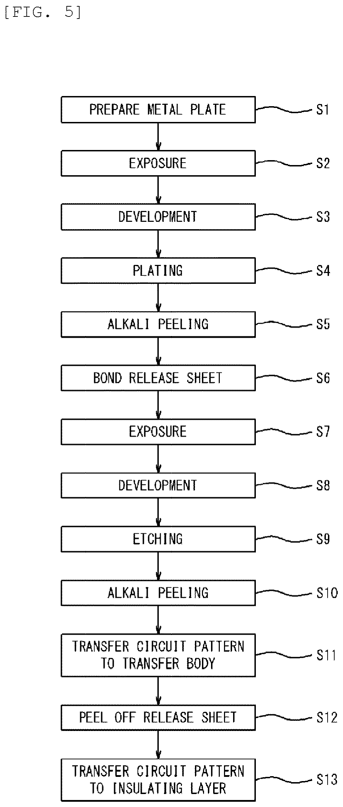

First, a metal plate 11 illustrated in Fig. 2A is prepared (step S1 in Fig. 5). The metal plate 11 is a plate made of a metal such as aluminum or copper, and in the present embodiment, a copper plate having a thickness of 0.5 to 2.0 mm is used as described above.

Next, as illustrated in Fig. 2B, a dry film (dry film 12 for a plating step) is bonded to the surface of the metal plate 11, and an exposure film (exposure film 13 for a plating step) is further disposed on the surface of the dry film 12 for a plating step. The exposure film 13 for a plating step has an opening in a portion (portion where the conductor portion 2a is not provided) between the adjacent conductor portions 2a in the circuit pattern 2 illustrated in Fig. 1. Note that, as illustrated in Figs. 1A to 1C, the electroless Ni-P/Au plating film 2b of the present embodiment is provided so as to be located inside the edge portion of the surface of the conductor portion 2a at a place where no opening is formed in the exposure film 13 for a plating step. The opening of the exposure film 13 for a plating step is formed to meet these conditions. Then, the exposure film 13 for a plating step is irradiated with light from an exposure device (not illustrated) to perform exposure (step S2 in Fig. 5). When the exposure is performed, the portion of the dry film 12 for a plating step located immediately below the opening is cured by the light passing through the opening of the exposure film 13 for a plating step.

Thereafter, development for removing an uncured portion of the dry film 12 for a plating step by exposure is performed by a developing device (not illustrated) (step S3 in Fig. 5). As a result, on the surface of the metal plate 11, a portion cured by exposure in the dry film 12 for a plating step remains in the portion (portion where the conductor portion 2a is not provided) between the adjacent conductor portions 2a in the circuit pattern 2 illustrated in Fig. 1A (see Fig. 2C).

Thereafter, plating is applied to the metal plate 11 illustrated in Fig. 2C (step S4 in Fig. 5). The plating on the metal plate 11 is performed, for example, by immersing the metal plate 11 in a plating bath containing a plating solution for a predetermined time. In the present embodiment, electroless Ni-P/Au plating is applied to the metal plate 11. Here, since it is not necessary to plate the back surface and the side surface of the metal plate 11, these surfaces are masked. Since the back surface and the side surface of the metal plate 11 are flat, masking can be performed without any trouble. By performing step S4, the electroless Ni-P/Au plating film 2b is provided on a portion of the surface of the metal plate 11 where the dry film 12 for a plating step does not remain as illustrated in Fig. 2D.

Thereafter, the dry film 12 for a plating step remaining on the surface of the metal plate 11 is removed with an alkali solution by an alkali peeling device (not illustrated) (step S5 in Fig. 5). After step S5 is performed, as illustrated in Fig. 2E, the electroless Ni-P/Au plating film 2b is partially provided on the surface of the metal plate 11. Note that the electroless Ni-P/Au plating film 2b is provided at a position where the conductor portion 2a is located in the circuit pattern 2 illustrated in Fig. 1.

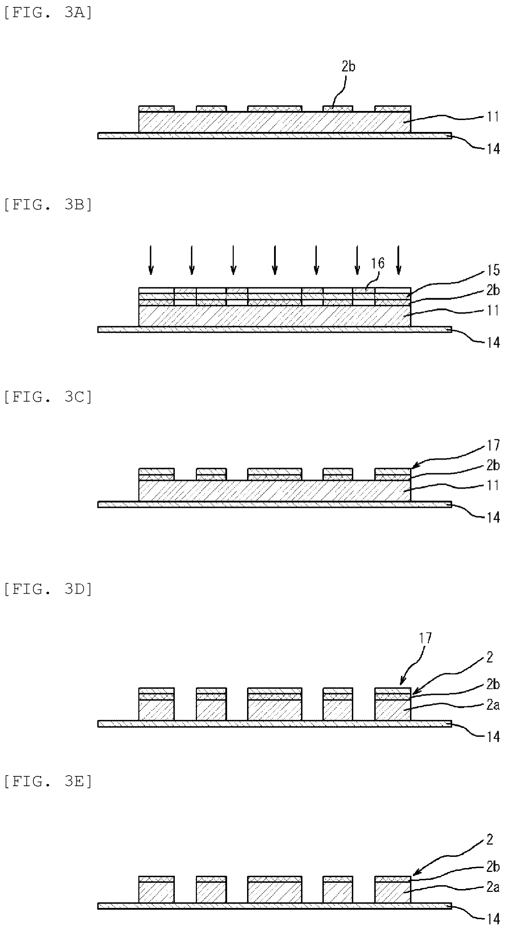

After the electroless Ni-P/Au plating film 2b is provided on the surface of the metal plate 11 in this manner, as illustrated in Fig. 3A, a release sheet 14 is bonded to the back surface of the metal plate 11 (step S6 in Fig. 5). As the release sheet 14, for example, various sheets capable of reducing an initial adhesive force by applying heat or irradiating ultraviolet rays can be used. The release sheet 14 of the present embodiment is a UV sheet having a property that the initial adhesive force is reduced by ultraviolet irradiation.

Thereafter, as illustrated in Fig. 3B, a dry film (dry film 15 for an etching step) is bonded to the surface of the metal plate 11 where the electroless Ni-P/Au plating film 2b is provided, and an exposure film (exposure film 16 for an etching step) is further disposed on the surface of the dry film 15 for an etching step. The exposure film 16 for an etching step has an opening in a portion where the electroless Ni-P/Au plating film 2b is provided. Then, the exposure film 16 for an etching step is irradiated with light from an exposure device (not illustrated) to perform exposure (step S7 in Fig. 5).

Thereafter, development for removing an uncured portion of the dry film 15 for an etching step by exposure is performed by a developing device (not illustrated) (step S8 in Fig. 5). As a result, on the surface of the metal plate 11, the portion provided with the electroless Ni-P/Au plating film 2b is covered with the portion cured by exposure in the dry film 15 for an etching step, and otherwise, the surface of the metal plate 11 is exposed (see Fig. 3C). Hereinafter, the dry film 15 for an etching step remaining on the surface of the metal plate 11 after development is referred to as a resist pattern 17.

Thereafter, the metal plate 11 including the resist pattern 17 is etched by an etching device (not illustrated) (step S9 in Fig. 5). As a result, the metal plate 11 is dissolved so as to penetrate in the thickness direction at the portion where the opening of the resist pattern 17 is provided, and a plurality of electrically independent conductor portions 2a are formed on the release sheet 14 as illustrated in Fig. 3D. Note that the etching can be performed by, for example, a device that sprays an etching solution toward the resist pattern 17 (see, for example, WO 2022/102357 A).

Thereafter, the resist pattern 17 covering the surface of the electroless Ni-P/Au plating film 2b is removed with an alkaline solution by an alkali peeling device (not illustrated) (step S10 in Fig. 5). After step S10 is performed, as illustrated in Fig. 3E, the circuit pattern 2 in which the electroless Ni-P/Au plating film 2b is provided on the surface of the conductor portion 2a is formed on the release sheet 14.

As described above, in the method for producing a circuit pattern of the present embodiment, step S6 of bonding the release sheet 14 to the back surface of the metal plate 11 is performed after step S4 of performing plating. That is, since the release sheet 14 is not provided on the back surface of the metal plate 11 in step S4 of performing plating, erosion of Ni or Au as illustrated in Fig. 7B does not occur.

Then, the circuit board 1 illustrated in Fig. 1 can be produced by performing the following method for producing a circuit board subsequent to the above-described method for producing a circuit pattern.

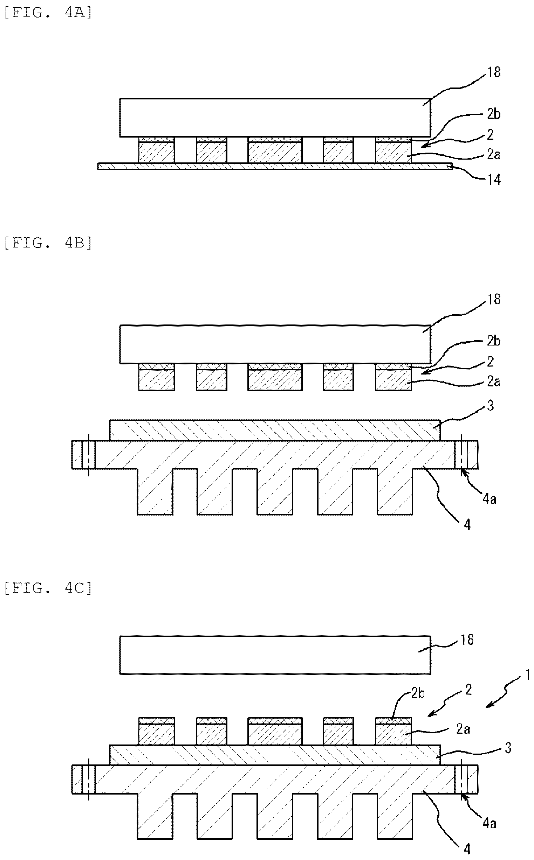

In the method for producing a circuit board of the present embodiment, after step S10 described above, a step of pressing a transfer body 18 against the surface of the circuit pattern 2 is performed as illustrated in Fig. 4A (step S11 in Fig. 5). The transfer body 18 includes, for example, a urethane cushion material having an adhesive layer provided on a surface thereof, and a backing plate laminated on a back surface of the cushion material. By pressing the surface of the transfer body 18 on which the adhesive layer is provided against the surface of the circuit pattern 2, the circuit pattern 2 is held by being bonded to the transfer body 18.

Next, the release sheet 14 bonded to the back surface of the circuit pattern 2 is irradiated with ultraviolet rays to reduce the adhesive force of the release sheet 14, and the release sheet 14 is peeled off from the circuit pattern 2 (step S12 in Fig. 5). That is, by performing steps S11 and S12, the circuit pattern 2 held by the release sheet 14 is transferred to the transfer body 18.

Thereafter, as illustrated in Fig. 4B, the circuit pattern 2 held by the transfer body 18 is pressed against the insulating layer 3 laminated on the base substrate 4 and heated. In the present embodiment, the transfer body 18 is pressed in a vacuum atmosphere at a predetermined temperature using a vacuum press device. Then, as illustrated in Fig. 4C, the transfer body 18 is peeled off after the insulating layer 3 is cured so as to transfer the circuit pattern 2 to the insulating layer 3 (step S13 in Fig. 5). Through such steps, the circuit board 1 is completed.

Note that, in producing the circuit board 1, a method of laminating the metal plate 11 on the base substrate 4 with the insulating layer 3 interposed therebetween, and etching and plating this laminate is also conceivable. However, in this method, etching and plating on the base substrate 4 has to be prevented, and thus the base substrate 4 has to be masked, but since the base substrate 4 is provided with fins and the through hole 4a, it is difficult to mask these, and there is a difficulty in workability. On the other hand, according to the method for producing a circuit board of the present embodiment, since the circuit pattern 2 that has already been etched and plated is laminated on the base substrate 4, masking on the base substrate 4 becomes unnecessary, and workability is not impaired.

As illustrated in Figs. 1A and 1B, the electroless Ni-P/Au plating film 2b in the circuit pattern 2 of the present embodiment is provided only on the surface of the conductor portion 2a, and is not provided on the side surface of the conductor portion 2a. That is, since the amount of expensive Au used can be reduced as compared with the case illustrated in Figs. 7A and 7B, the cost can be reduced. The electroless Ni-P/Au plating film 2b is located inside the edge portion of the surface of the conductor portion 2a as illustrated in Fig. 1C. That is, when an electronic component is soldered to the circuit pattern 2 of the present embodiment, the solder substantially remains in the electroless Ni-P/Au plating film 2b having favorable wettability, so that it is possible to prevent the problem in that the solder adheres to the outside of the surface of the conductor portion 2a.

Although one embodiment of the present invention has been described above, the present invention is not limited to the specific embodiment, and various modifications and alterations can be made within the scope of the gist of the present invention described in the claims unless otherwise limited in the above description. For example, the configuration of the above-described embodiment can be appropriately added or deleted, and the configuration of one embodiment can be provided in another embodiment. The effects of the above-described embodiment are merely examples of the effects caused by the present invention, and do not mean that the effects of the present invention are limited to the above effects.

For example, the circuit pattern 2 is not limited to one in which etching is performed from one surface of the metal plate 11 as illustrated in the drawings, and includes one in which etching is performed from both surfaces of the metal plate 11 as illustrated in Fig. 11 of WO 2022/102357 A and the like. In using the metal plate 11 etched from both surfaces, steps S1 to S5 illustrated in Fig. 5 of WO 2022/102357 A are performed as step S1 illustrated in Fig. 5 to prepare the metal plate 11 having recesses on the front and back surfaces as illustrated in Fig. 11 of this document. Thereafter, with respect to the metal plate 11 having recesses on the front and back surfaces, steps S2 to S13 in Fig. 5 may be sequentially performed in such a manner that the dry film 12 for a plating step is bonded to the surface of the metal plate 11 as shown in Fig. 2B, and further, the exposure film 13 for a plating step is disposed on the surface of the dry film 12 for a plating step to perform exposure (step S2 in Fig. 5).

Note that, in the etching of the metal plate 11, it is preferable to perform the etching from one surface when the thickness is 0.8 mm or less, and it is preferable to perform the etching from both surfaces when the thickness is more than 0.8 mm and 2.0 mm or less, in consideration of the accuracy (such as an etch factor) after the etching and the time required for the etching.

### Reference Signs List

- 1: Circuit board
- 2: Circuit pattern
- 2a: Conductor portion
- 2b: Electroless Ni-P/Au plating film
- 3: Insulating layer
- 4: Base substrate
- 11: Metal plate
- 14: Release sheet
- 18: Transfer body

## Claims

1. A method for producing a circuit pattern, the method comprising:
a step of plating a predetermined portion on a surface of a metal plate;
a step of bonding a release sheet to a back surface of the plated metal plate;
a step of providing a resist pattern covering the plating on the surface of the metal plate; and
a step of forming a circuit pattern bonded to the release sheet by etching the metal plate provided with the resist pattern.

2. A method for producing a circuit board by laminating the circuit pattern obtained by the method for producing a circuit pattern according to claim 1 on an insulating layer laminated on a base substrate, the method comprising:
a step of transferring the circuit pattern to a transfer body;
a step of peeling off the release sheet from the circuit pattern; and
a step of transferring the circuit pattern from the transfer body to the insulating layer.

3. A circuit pattern in which a surface is plated and a release sheet is bonded to a back surface, wherein
the plating is located inside an edge portion of the surface in the circuit pattern.
